**Europäisches Patentamt**

**European Patent Office**

**Office européen des brevets**

(19)

(11) Numéro de publication : **0 482 967 A1**

# (12) DEMANDE DE BREVET EUROPEEN

(21) Numéro de dépôt : **91402490.6**

(22) Date de dépôt : **18.09.91**

(51) Int. Cl.⁵ : **H03B 9/10**

(30) Priorité : **23.10.90 FR 9013123**

(43) Date de publication de la demande :
**29.04.92 Bulletin 92/18**

(84) Etats contractants désignés :
**BE DE ES GB IT LU NL SE**

(71) Demandeur : **DASSAULT ELECTRONIQUE**
**55, quai Marcel Dassault**
**F-92214 Saint-Cloud (FR)**

(72) Inventeur : **Demazure, Eric**
**105, route de Neauphie**
**F-78112 Fourqueux (FR)**

(74) Mandataire : **Plaçais, Jean-Yves et al**
**Cabinet Netter, 40, rue Vignon**
**F-75009 Paris (FR)**

(54) **Dispositif d'émission hyperfréquence.**

(57)     Les moyens de commande (2) du magnétron comprennent une entrée de commande (20,21) pour une source haute tension continue, une sortie de commande courant/tension (27,28) pour le magnétron (1), un tube électronique (22) dont la maille cathode-anode est connectée entre l'entrée et la sortie de commande. Sont également prévus des moyens de régulation (23) de la tension grille-cathode du tube, possédant une première entrée de régulation (235) reliée à l'anode (220) du tube (22) pour recevoir une première information de courant représentative du courant délivré à la sortie de commande, une deuxième entrée de régulation (236) pour recevoir une deuxième information de courant représentative d'un courant de consigne prédéterminé, et une sortie de régulation (237) reliée à la grille du tube (222) pour délivrer une tension grille-cathode dépendant des deux informations de courant, et des moyens d'activation (29) de ces moyens de régulation propres à appliquer ladite deuxième information de courant à la deuxième entrée de régulation en fonction d'une information de commande (25) reliée à la séquence d'émission du magnétron.

EP 0 482 967 A1

L'invention concerne les dispositifs d'émission hyperfréquence, du type comprenant un magnétron et des moyens de commande de celui-ci.

La commande des magnétrons est actuellement généralement effectuée en utilisant des transformateurs élévateurs de tension et/ou des interrupteurs de puissance tels que des transistors à effet de champ fonctionnant en tout ou rien.

De tels moyens de commande souffrent d'inconvénients très pénalisants qui, selon les diverses configurations de structure envisagées, vont de la médiocrité du rendement et de la mauvaise tenue en température, à des durées de décharge trop longues de la capacité parasite du magnétron, en passant par une dégradation des fronts de montée et de descente des impulsions d'émission du magnétron occasionnées par des capacités parasites importantes des constituants du dispositif.

L'invention vient proposer ici un dispositif d'émission hyperfréquence d'une structure radicalement différente visant à apporter une solution plus satisfaisante à ces problèmes.

Un but de l'invention est de permettre de brèves durées de charge et de décharge de la capacité parasite du magnétron avec des fronts raides de montée et de descente des impulsions d'émission de celui-ci, tout en évitant l'inconvénient d'une trop forte puissance dissipée dant le circuit de commande.

Un autre but de l'invention est de rendre les caractéristiques de commande du magnétron quasi-indépendantes de l'environnement extérieur, notamment des conditions de température.

L'invention s'applique ainsi très avantageusement, mais non limitativement, aux magnétrons utilisés en émetteurs cohérents à haute fréquence de récurrence (HFR), qui doivent notamment présenter une très bonne pureté spectrale dans une bande de fréquences choisie autour de la fréquence porteuse, ainsi qu'une fréquence de récurrence pouvant être variable et atteindre des valeurs élevées, correspondant ainsi à des impulsions d'émission courtes, et ce même à facteur de forme élevé.

Le dispositif proposé est du type de celui évoqué ci-avant.

Selon la principale caractéristique de l'invention, les moyens de commande comprennent:

– une entrée de commande pour une source haute tension continue,

– une sortie de commande courant/tension pour le magnétron, en particulier à haute fréquence de récurrence et facteur de forme élevé,

– un tube électronique, tel qu'une triode, dont la maille cathode-anode est connectée entre l'entrée et la sortie de commande,

– des moyens de régulation de la tension grille-cathode du tube, possédant une première entrée de régulation reliée à l'anode du tube pour recevoir une première information de courant représentative du courant délivré à la sortie de commande, une deuxième entrée de régulation pour recevoir une deuxième information de courant représentative d'un courant de consigne prédéterminé, et une sortie de régulation reliée à la grille du tube pour délivrer une tension grille-cathode dépendant des deux informations de courant, et

– des moyens d'activation de ces moyens de régulation propres à appliquer ladite deuxième information de courant à la deuxième entrée de régulation en fonction d'une information de commande reliée à la séquence d'émission du magnétron.

Selon un mode de réalisation de l'invention, les moyens de régulation comprennent:

– un amplificateur opérationnel dont la sortie est reliée à la grille du tube,

– un premier transformateur de courant dont le primaire est connecté entre l'anode du tube et la sortie de commande, et dont le secondaire est relié à l'une des entrées de l'amplificateur opérationnel, et

– un deuxième transformateur de courant dont le primaire est relié à la deuxième entrée de régulation, et dont le secondaire est relié à l'autre entrée de l'amplificateur opérationnel.

Il est également particulièrement avantageux que les moyens de commande comportent une capacité connectée entre les bornes de l'enroulement primaire du premier transformateur de courant, afin de charger encore plus rapidement la capacité parasite du magnétron.

Selon un mode de réalisation de l'invention, l'information de commande comporte une impulsion de tension dont les caractéristiques sont reliées à la trame de récurrence du magnétron, tandis que les moyens d'activation comportent une résistance réglable reliée au primaire du deuxième transformateur de courant et au bornes de laquelle est appliquée ladite impulsion de tension.

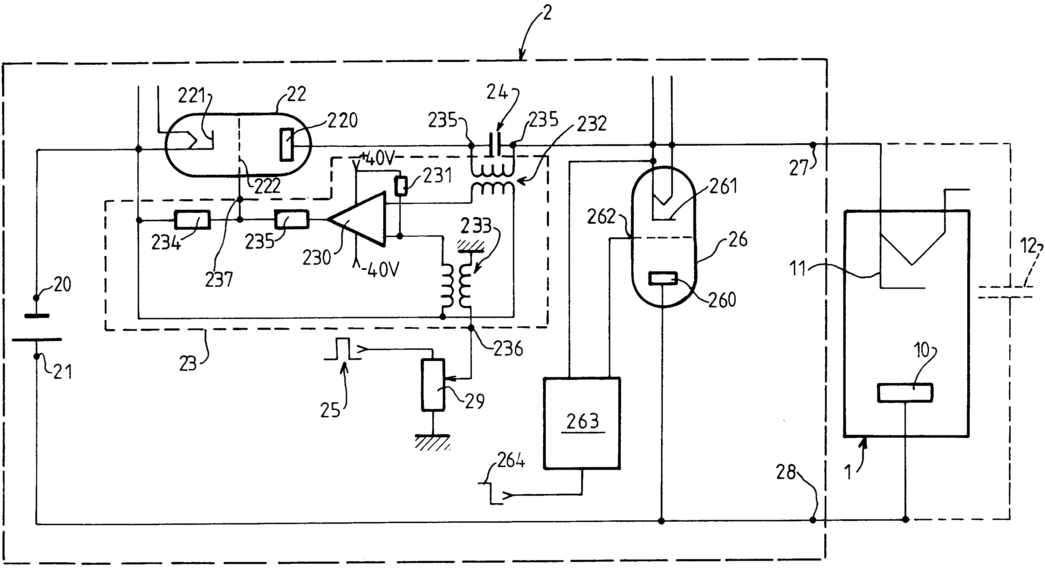

D'autres avantages et caractéristiques de l'invention apparaîtront à l'examen de la description détaillée ci-après et du dessin annexé sur lequel la figure unique est un synoptique schématique d'un mode de réalisation du dispositif selon l'invention.

La figure unique comporte des éléments de caractère certain. A ce titre elle fait partie intégrante de la description et pourra non seulement servir à mieux faire comprendre la description détaillée ci-après mais aussi contribuer, le cas échéant, à la définition de l'invention.

Sur cette figure, la référence 1 désigne un magnétron hyperfréquence, par exemple celui disponible auprès de la société britannique EEV (English Electric Valves) sous la référence MG5241, dont la capacité parasite cathode-anode 12 est représentée en tireté. Ce magnétron est commandé par des moyens de commande 2 possédant une entrée de commande 20, 21 pour une source haute tension continue, typiquement de l'ordre de -2000 Volts, non régulée et supérieure à la tension de commande du magnétron, ainsi qu'une sortie courant/tension 27, 28 reliée à la cathode 11 et à l'anode 10 du magnétron.

Un premier élément important de ces moyens de commande 2 consiste en une triode 22 dont la cathode 221 est reliée à la borne négative 20 de l'entrée de commande.

Un deuxième élément important des moyens de commande réside en des moyens de régulation 23 de la tension grille-cathode de la triode 22, qui de ce fait, comme on le verra ci-après, pourra agir en tant qu'interrupteur linéaire (ou progressif) par opposition à un interrupteur fonctionnant en tout ou rien.

Ces moyens de régulation comportent une première entrée de régulation 235 constituée par les deux bornes de l'enroulement primaire d'un premier transformateur de courant 232. Ces deux bornes 235 sont connectées en série avec l'anode 220 de la triode 22 et avec la cathode 11 du magnétron par l'intermédiaire de la borne de sortie 27.

L'enroulement secondaire du transformateur de courant 232 est relié d'une part, à la borne 20 de l'entrée haute tension et, d'autre part, à l'entrée positive d'un amplificateur opérationnel 230 alimenté par une tension de ± 40 Volts par rapport à la haute tension de -2000 Volts.

Entre la sortie de l'amplificateur opérationnel 230 et la cathode 221 de la triode 22 est disposé un pont résistif 234, 235 dont le point milieu constitue une sortie de régulation 237 des moyens de régulation 23, reliée à la grille 222 de la triode 22;

L'entrée négative de l'amplificateur opérationnel 230 est reliée d'une part à la tension +40 Volts par une résistance d'offset 231, et d'autre part à l'une des bornes de l'enroulement secondaire d'un deuxième transformateur de courant 233. L'autre borne de cet enroulement secondaire est reliée d'une part à la cathode 221 du tube 22 et, d'autre part à l'enroulement secondaire du premier transformateur de courant 232.

L'enroulement primaire du transformateur de courant 233 est connecté entre la masse et une deuxième entrée de régulation 236 des moyens de régulation 23.

Cette entrée de régulation 236 est reliée à une résistance réglable 29 aux bornes de laquelle est susceptible d'être appliquée une information de commande, par exemple une impulsion de tension, reliée à la séquence d'émission du magnétron.

On verra plus loin que cette résistance réglable 29 permet, en réponse à l'impulsion de tension 25, d'activer la boucle de régulation 23 en délivrant à l'entrée de régulation 236 une information de courant représentative d'un courant de consigne prédéterminé.

Une capacité 24, dont la fonction sera explicitée ci-après, est très avantageusement connectée entre les deux bornes 235 de l'enroulement primaire du transformateur de courant 232.

Alors que, comme on le verra ci-après, la triode 22 et les moyens de régulation 23 contribuent à la charge de la capacité parasite 12 du magnétron ainsi qu'à la régulation de la puissance dissipée sur la grille 222 de la triode 22, il est prévu également des moyens de court-circuit des bornes 27 et 28 du magnétron afin d'assurer la décharge de la capacité parasite de celui-ci.

Ces moyens de court-circuit comprennent une deuxième triode 26 dont les cathode 261 et anode 260 sont respectivement reliées aux bornes homologues 11 et 10 du magnétron. La grille 262 de cette triode 26 est reliée à un circuit de commande 263 comportant un monostable activé par une deuxième information de commande 264 qui, comme on le verra ci-après, est reliée à la première information de commande 25.

En l'absence d'impulsions de tension de commande 25 sur la résistance réglable 29, est appliquée, par l'intermédiaire de la tension d'alimentation +40 Volts et la résistance 231, une tension d'offset sur l'entrée négative de l'amplificateur 230. Une tension négative est donc appliquée à la sortie 237 des moyens de régulation, ce qui a pour effet de produire une tension grille-cathode négative bloquant la triode 22.

Les caractéristiques des impulsions de commande successives 25 sont reliées à la trame de récurrence du magnétron, c'est-à-dire à la fréquence de récurrence et au facteur de forme des impulsions d'émission. On rappelle ici que le facteur de forme est le rapport de la durée d'une impulsion d'émission par rapport à la durée totale séparant l'occurrence de deux impulsions d'émission.

Lors de l'apparition d'une impulsion de tension de commande 25, un courant de consigne est donc appliqué à l'entrée de régulation 236, ce qui se traduit, après passage dans le transformateur de courant 233 par un créneau de tension négative à l'entrée négative de l'amplificateur opérationnel, et par conséquent à un créneau de tension positive à la sortie de régulation 237. La grille 222 de la triode 22 est donc portée (relativement à la tension cathode) à un potentiel positif maximum ("surpolarisation"), ce qui rend la triode 22 conductrice et permet ainsi de charger très rapidement la capacité parasite 12 du magnétron.

A cet effet, la capacité 24, connectée entre les bornes de l'enroulement primaire de transformateur de courant 232, agissant en tant que circuit intégrateur, permet d'obtenir à l'apparition de cette impulsion de tension de commande, une pente de courant très importante en un temps bref (typiquement de l'ordre de 100 nanosecondes) ce qui retarde le fonctionnement de la boucle de régulation 23 et réduit encore le temps de charge de la capacité parasite 12 du magnétron.

Lorsque cette durée de charge est atteinte le courant magnétron apparaît et circule alors dans l'enroulement primaire du transformateur 232. Les moyens de régulation 23 vont alors délivrer à la grille 222 de la triode une tension dépendant de ce courant magnétron et du courant de consigne. En d'autres termes, le potentiel de la grille de la triode est autorégulé sur une valeur de consigne correspondant à l'information du courant de consigne appliquée à l'enroulement primaire du transformateur 233. La puissance dissipée sur la grille 222 de cette triode devient alors compatible avec un fonctionnement fiable et durable de celle-ci en évitant sa destruction.

L'amplitude des impulsions de commande 25 ainsi que la valeur de la résistance réglable 29 sont ajustées pour délivrer un courant de consigne permettant d'obtenir un rendement maximum du magnétron compte tenu de ses caractéristiques propres.

Les moyens de régulation 23 permettent en outre d'ajuster le courant débitant dans le magnétron sur le courant de consigne prédéterminé quelles que soient les variations éventuelles d'impédance du magnétron dues aux conditions extérieures, par exemple les conditions de température.

Lorsque le front descendant de l'impulsion de commande 25 apparaît, le courant traversant le transformateur 233 chute à zéro alors que celui traversant le transformateur 232 et, par conséquent le magnétron, n'est pas nul. En conséquence, il se produit en sortie de l'amplificateur opérationnel 230 un créneau de tension négative donnant naissance à une tension grille-cathode négative ce qui a pour effet de bloquer la triode 22 et, par conséquent le magnétron. La décharge de la capacité parasite 12 du magnétron se produit alors par le court-circuit des bornes 27 et 28 à l'aide de la triode 26, pendant un temps défini par le monostable 263 commandant la grille 262. Cette durée de décharge (typiquement de l'ordre de 200 nanosecondes) est comptée à partir de l'apparition du front descendant de l'impulsion de commande 25, ce front descendant agissant ici comme une deuxième information de commande 264.

Le dispositif selon l'invention permet ainsi de ne pas laisser subsister aux bornes du magnétron un résidu de tension qui serait alors à l'origine d'une émission parasite de bruit, qui s'avère inacceptable pour un magnétron utilisé en émetteur cohérent. Concrètement, ce dispositif permet d'obtenir un seuil acceptable maximum de bruit égal à -164 dbm/hertz.

Les avantages du dispositif selon l'invention sont les suivants, outre ceux déjà évoqués :
– les charge et décharge rapides ainsi que l'absence de résidus de tension permettent d'obtenir des fronts raides de montée et de descente de l'impulsion d'émission, et ceux-ci peuvent être corrigés automatiquement en fonction d'éventuelles variations d'impédance interne du magnétron, par exemple ;
– la régulation du courant magnétron s'effectue impulsion à impulsion, et est intégrée directement aux moyens de commande du magnétron en étant indépendante, structurellement, du montage d'alimentation haute tension ; ceci permet d'opérer avec une haute tension non régulée.
– une réponse instantanée du magnétron peut être obtenue lors d'une modulation de largeur d'impulsion (PWM) puisque les caractéristiques d'émission du magnétron sont commandées impulsion à impulsion.

L'invention permet ainsi d'utiliser le magnétron en émetteur cohérent à haute fréquence de récurrence pouvant atteindre des valeurs supérieures à 600 kilohertz, avec des impulsions d'émission présentant un facteur de forme élevé, typiquement de l'ordre de 0,25. Une très bonne pureté spectrale peut être obtenue dans une bande de fréquences (typiquement de l'ordre de 300 kilohertz) autour de la porteuse pour un magnétron accordé par exemple sur une fréquence de 10 gigahertz.

Un rendement des moyens de commande nettement supérieur à 50% peut être alors obtenu, même avec des fréquences de récurrence élevées et malgré les capacités parasites des différents constituants.

L'invention n'est pas limitée au mode de réalisation ci-dessus décrit mais en embrasse toutes les variantes contenues dans le cadre des revendications ci-après.

Bien entendu, certains des moyens décrits ci-dessus peuvent être omis dans les variantes où ils ne servent pas.

**Revendications**

1. Dispositif d'émission hyperfréquence, comprenant un magnétron et des moyens de commande de celui-ci,
caractérisé en ce que les moyens de commande (2) comprennent :
– une entrée de commande (20,21) pour une source haute tension continue,
– une sortie de commande courant/tension (27,28) pour le magnétron (1),
– un tube électronique (22) dont la maille cathode-anode est connectée entre l'entrée et la sortie de commande,
– des moyens de régulation (23) de la tension grille-cathode du tube, possédant une première entrée de régulation (235) reliée à l'anode (220) du tube (22) pour recevoir une première information de courant représentative du courant délivré à la sortie de commande, une deuxième entrée de régulation (236) pour recevoir une deuxième information de courant représentative d'un courant de consigne prédéterminé, et une sortie de régulation (237) reliée à la grille du tube (222) pour délivrer une tension grille-cathode dépendant des deux informations de courant, et

– des moyens d'activation (29) de ces moyens de régulation propres à appliquer ladite deuxième information de courant à la deuxième entrée de régulation en fonction d'une information de commande (25) reliée à la séquence d'émission du magnétron.

2. Dispositif selon la revendication 1, caractérisé en ce que le tube électronique (22) est une triode.

3. Dispositif selon la revendication 1 ou 2, caractérisé en ce que les moyens de régulation comprennent:

– un amplificateur opérationnel (230) dont la sortie est reliée à la grille du tube,

– un premier transformateur de courant (232) dont le primaire est connecté entre l'anode du tube et la sortie de commande, et dont le secondaire est relié à l'une des entrées de l'amplificateur opérationnel, et

– un deuxième transformateur de courant (233) dont le primaire est relié à la deuxième entrée de régulation, et dont le secondaire est relié à l'autre entrée de l'amplificateur opérationnel.

4. Dispositif selon l'une des revendications précédentes, caractérisé en ce que les moyens de commande comportent une capacité (24) connectée entre les bornes de l'enroulement primaire du premier transformateur de courant (232).

5. Dispositif selon l'une des revendications précédentes, caractérisé en ce que l'information de commande comporte une impulsion de tension (25) tandis que les moyens d'activation comportent une résistance réglable (29) reliée au primaire du deuxième transformateur de courant (233) et au bornes de laquelle est appliquée ladite impulsion de tension (25).

6. Dispositif selon l'une des revendications précédentes, caractérisé en ce que le magnétron est un magnétron hyperfréquence à haute fréquence de récurrence.

7. Dispositif selon la revendication 6, caractérisé en ce que le magnétron présente des impulsions d'émission à facteur de forme élevé.

8. Dispositif selon la revendication 5 prise en combinaison avec l'une des revendications 6 et 7, caractérisé en ce que les caractéristiques de l'impulsion de commande sont reliées à la trame de récurrence du magnétron.

9. Dispositif selon l'une des revendications précédentes, caractérisé en ce que les moyens de commande (262,263) comportent des moyens propres à court-circuiter les bornes du magnétron en réponse à une deuxième information de commande (264).

10. Dispositif selon la revendication 9, caractérisé en ce que les moyens de court-circuit comportent un deuxième tube électronique (26), en particulier une triode, dont la maille cathode-anode est connectée entre les bornes du magnétron (1), ainsi qu'un circuit monostable (263) relié à la grille du deuxième tube et activé par ladite deuxième information de commande (264).

11. Dispositif selon la revendication 5 prise en combinaison avec l'une des revendications 9 et 10, caractérisé en ce que la deuxième information de commande (264) comporte l'apparition du front descendant de ladite impulsion de tension (25).

EP 0 482 967 A1

EP 0 482 967 A1

**Office européen des brevets**

**RAPPORT DE RECHERCHE EUROPEENNE**

Numero de la demande

EP 91 40 2490

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 318 165  (KORNRUMPH et al.) * Figure 2; colonne 1, ligne 56 - colonne 2, ligne 32 * --- | 1 | H 03 B    9/10 |
| A | US-A-3 125 728  (J.L. FASULO) * Figure unique; colonne 3, lignes 4-46 * --- | 1 | |
| A | US-A-2 737 586  (R.A. FLOWER) * Figure 1; colonne 1, ligne 66 - colonne 4, ligne 58 * --- | 1 | |
| A | US-A-3 611 017  (R.R. FREELAND) * Figure unique; résumé * --- | 1 | |
| A | US-A-4 012 617  (BURKE et al.) * Figure 1; résumé * ----- | 1 | |

**DOMAINES TECHNIQUES RECHERCHES (Int. Cl.5)**

H 03 B
H 03 L

Le présent rapport a été établi pour toutes les revendications

| Lieu de la recherche | Date d'achèvement de la recherche | Examinateur |
|---|---|---|
| LA HAYE | 06-12-1991 | PEETERS M.M.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

EPO FORM 1503 03.82 (P0402)

7